Europäisches Patentamt

European Patent Office

Office européen des brevets

(19)

(11) Veröffentlichungsnummer: **0 152 818**
**A2**

(12) # EUROPÄISCHE PATENTANMELDUNG

(21) Anmeldenummer: 85100886.2

(22) Anmeldetag: 29.01.85

(51) Int. Cl.⁴: **H 01 L 23/48,** H 01 L 23/52, H 01 L 25/04

(30) Priorität: 23.02.84 DE 3406528

(43) Veröffentlichungstag der Anmeldung: 28.08.85 Patentblatt 85/35

(84) Benannte Vertragsstaaten: **AT CH DE FR GB IT LI NL SE**

(71) Anmelder: **BROWN, BOVERI & CIE Aktiengesellschaft, Kallstadter Strasse 1, D-6800 Mannheim 31 (DE)**

(72) Erfinder: **Nippert, Georg, Dipl.-Phys., Hochheimer Strasse 40, D-6520 Worms (DE)**
Erfinder: **Hahn, Bertold, Schillerstrasse 28, D-6844 Lampertheim (DE)**
Erfinder: **Gobrecht, Jens, Dr. Dipl.-Phys., Birchhof 6, CH-5412 Gebenstorf (CH)**

(74) Vertreter: **Kempe, Wolfgang, Dr. et al, c/o Brown, Boveri & Cie AG Postfach 351, D-6800 Mannheim 1 (DE)**

(54) **Leistungshalbleitermodul.**

(57) Zur Vermeidung aufwendiger Lötformen für die Herstellung von Modulen mit gesteuerten Leistungshalbleiterbauelementen wird ein Leistungshalbleitermodul (1) mit mindestens zwei parallelen Substraten (2, 3) vorgeschlagen, wobei zwischen jeweils zwei Substraten (2, 3) mindestens ein gesteuertes Leistungshalbleiterbauelement (5) angeordnet ist, das direkt oder über Ausgleichstücke (7) mit einer Metallisierung (4) auf den Substraten (2, 3) über und unter dem gesteuerten Leistungshalbleiterbauelement (5) kontaktiert ist. Sämtliche Leitungsverbindungen lassen sich dabei in Form von Leiterbahnen (9) auf keramische Platten (2, 3) oder Hülsen (17) oder Kontaktstempel (10) zwischen Substraten (2, 3) realisieren, so daß Kontaktbügel entfallen.

0152818

B R O W N , B O V E R I & C I E AKTIENGESELLSCHAFT
Mannheim                                      3. Okt. 1984
Mp.-Nr. 519/84 Ausl.                          ZPT/P3-Sf/Bt

## Leistungshalbleitermodul

Die Erfindung bezieht sich auf ein Leistungshalbleitermodul nach dem Oberbegriff des Anspruchs 1. Solche Module in elektrisch isolierter Ausführung weisen eine ein- oder beidseitig metallisierte Keramikplatte als Bodenplatte auf sowie mindestens eine weitere parallel dazu angeordnete Keramikplatte.

Mit Leistungshalbleitermodulen können Stromrichterschaltungen ganz oder teilweise realisiert werden. Soweit die dazu erforderlichen Verbindungen der einzelnen Elemente nicht mit Leiterbahnen auf dem Substrat (metallisierte Keramik) realisiert werden können, verwendet man Kontaktbügel (auch Clips genannt) zur Verbindung oder stellt nach dem Auflöten von Halbleiterchips auf das Substrat die Verbindungen von Hand her. Zur Fixierung der Halbleiterchips, Kontaktbügel und sonstiger Bauteile ist eine Lötform erforderlich, damit die Teile während des Lötvorgangs ihre Position halten. Diese Lötform ist ein teueres Präzisionsteil und verursacht eine Reihe weiterer Nachteile. Da die Form nach der Lötung wieder entfernt wird, müssen alle Teile etwas Spiel in der Lötform haben. Während des Lötens verschieben sich diese
Teile im allgemeinen innerhalb dieser Toleranzen; im
ungünstigsten Fall liegen mehrere Halbleiterchips mit
ihren Rändern an der Lötform an und werden beim Auslösen
aus der Form beschädigt. Das ganze Modul ist somit Ausschuß. Hinzu kommt, daß sowohl bei reiner Handverlötung
als auch bei der Verwendung von Kontaktbügeln eine minimale Größe des Keramiksubstrats einzuhalten ist, die
nicht durch die Größe der verwendeten Chips, sondern
durch die technischen Möglichkeiten bei der Lötformherstellung bestimmt ist. Diese Größe übersteigt im allgemeinen die Größe, die zur Unterbringung der Chips erforderlich wäre, bei weitem, da zur Führung der Kontaktbügel eine minimale Stegbreite einzuhalten ist. Ein weiterer Nachteil der bisherigen Lösung ist, daß keine
räumliche Trennung von Verbindungen, die den Laststrom
führen, und von Hilfsverbindungen zur Steuerung möglich
ist. Bei komplexen Modulen sind außerdem verschiedenartige Kontaktbügel nötig; eine Standardisierung der einzelnen Montageteile ist nur in geringem Umfang möglich.

Ein Modul mit mehreren übereinander angeordneten Substraten ist aus der DE-OS 31 37 570 (Fig. 6 und zugehörige Beschreibung) bekannt. Dabei wird jedoch jede Platte nur auf ihrer Oberseite mit Halbleiterbauelementen
kontaktiert. Elektrische Verbindungen werden durch Kontaktbügel hergestellt und zur Lötung ist entweder eine
aufwendige Lötform oder Handlötung erforderlich.

Weiterhin ist aus der DE-PS 29 39 732 eine Halbleiterdiodenanordnung bekannt, bei der ein Modul mit sandwichartigem Aufbau vorgeschlagen wird. Dabei sind Halbleiterdiodenchips zwischen metallischen Keramikplatten angeordnet, wobei eine gemeinsame untere Keramikplatte und
mehrere obere Keramikplatten vorgesehen sind. Gesteuerte

519/84 Ausl.  3  0152818

Leistungshalbleiter und eine hybride Anordnung von Leistungshalbleitern und integrierten Schaltungen zur Informationsverarbeitung oder zur Ansteuerung von Leistungshalbleitern sind nicht vorgesehen.

Der Erfindung liegt davon ausgehend die Aufgabe zugrunde, Leistungshalbleitermodule anzugeben, bei denen vorgenannte Nachteile in der Herstellung vermieden werden und die mindestens einen gesteuerten Leistungshalbleiter enthalten.

Diese Aufgabe wird durch ein Leistungshalbleitermodul gemäß dem Anspruch 1 gelöst. Ausgestaltungen sind in den Unteransprüchen angegeben.

Die erfindungsgemäße Anordnung von Halbleiterbauelementen zwischen mindestens zwei parallelen Substraten hat nachstehende Vorteile:

Es ist keine komplizierte Lötform erforderlich. Die einzelnen Teile werden zur Vorbereitung der Lötung lediglich in einen einfachen Lötrahmen gesetzt. Diese Bestückung kann mit Hilfe von Bestückungsautomaten erfolgen. Sämtliche elektrischen Verbindungen zwischen den einzelnen Bauteilen und zu Kontaktsteckern können mit Hilfe von Leiterbahnen auf Keramik oder durch Kontaktstempel zwischen Substraten realisiert werden. Im Vergleich zum konventionellen Aufbau von Leistungshalbleitermodulen ergibt sich ein sehr kompakter Aufbau, der kleine Gehäuse ermöglicht. Man benötigt weniger Bauteile, die zudem standardisiert werden können. Änderungen im Modulaufbau sind einfacher zu realisieren und es sind nur wenige Arbeitsschritte bei der Modulherstellung erforderlich. Leistungsstromkreise und Steuerstromkreise können in verschiedene Leiterbahnebenen aufgeteilt werden.

Die Positionierung von Bauteilen vor und während des Lötvorganges kann auf unterschiedliche Weise erfolgen. Dazu sind z.B. keramische Zentrierstifte geeignet, die in Löcher der Deckplatte gesteckt und nach der Lötung entfernt werden und somit wiederverwendbar sind. Für Bauelemente mit Gate-Anschluß sind auch Zentrierhülsen geeignet, durch die ein Kontaktdraht, z.B. vorgebogen als Kontakthäkchen, geführt werden kann. Nach einer weiteren vorteilhaften Ausgestaltung kann die keramische Hülse außer zur Positionierung auch zur Herstellung elektrischer Verbindungen benutzt werden, wobei die Hülse an geeigneten Stellen mit einer Metallisierung versehen ist.

Kontaktanschlüsse können entweder nach oben geführt werden oder auch seitlich am Modul herausgeführt werden. Seitlich herausgeführte Kontakte können besonders vorteilhaft sein, wenn sowohl oben als auch unten am Modul Kühlkörper vorgesehen sind.

Weitere Vorteile der Erfindung ergeben sich aus den nachstehenden Ausführungsbeispielen, die anhand der Zeichnung erläutert werden.

Es zeigen:

Fig. 1    Schnitt durch einen Leistungshalbleitermodul mit zwei übereinander angeordneten Substraten und zwischengelegten Halbleiterchips,

Fig. 2    Detaildarstellung einer Alternative, bei der die Fixierung eines Halbleiterchips und die Herstellung elektrischer Verbindungen durch Verwendung metallisierter Keramikhülsen erfolgt,

Fig. 3    Detaildarstellung einer weiteren Alternative, bei der die Fixierung von Bauteilen mit keramischen Zentrierstiften erfolgt,

519/84 Ausl.    5    0152818

Fig. 4    Schaltungsschema einer Drehstrombrückenschaltung,

Fig. 5    Beispiel Drehstrombrückenschaltung, Oberseite
          der Grundplatte,

Fig. 6    Beispiel Drehstrombrückenschaltung, Unterseite
          der Deckplatte,

Fig. 7    Beispiel Drehstrombrückenschaltung, Oberseite
          der Deckplatte.

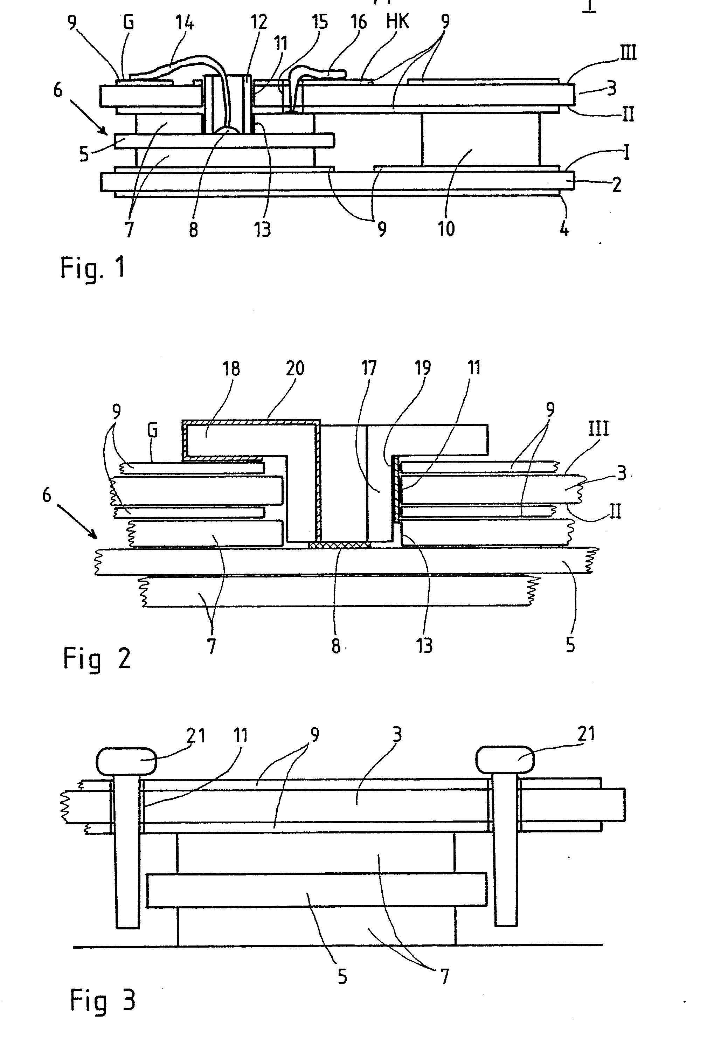

Fig. 1 zeigt einen Schnitt durch ein Leistungshalbleitermodul 1, das zwei Substrate, nämlich eine beidseitig
metallisierte Grundplatte 2 und eine ebenfalls beidseitig metallisierte Deckplatte 3 aufweist. Es sind jedoch
auch Ausführungen möglich, bei denen auf der Unterseite
der Grundplatte 2 keine Metallisierung 4 vorgesehen ist.
Bevorzugt werden durch Direct-Bonding hergestellte Substrate 2, 3 mit Kupfer auf Keramik, weil dabei eine gute
Haftung der Metallisierung 4 gegeben ist.

Zwischen der Grundplatte 2 und der Deckplatte 3 sind
gesteuerte Leistungshalbleiterbauelemente 5 und gegebenenfalls weitere Bauteile angeordnet. Im dargestellten
Beispiel ist ein vorgefertigtes und vorgelötetes Halbleiter-Sandwich 6 vorgesehen, das aus einem Halbleiterbauelement 5 und je einem Ausgleichstück 7 über und unter dem Halbleiterbauelement 5 besteht. Das obere Ausgleichstück 7 hat in der Mitte eine Öffnung 13 im Bereich des vorgelöteten Gate-Anschlusses 8 am Halbleiterbauelement 5. Das dargestellte Halbleiterbauelement 5
ist ein Thyristor. Ausgleichstücke 7 sind zweckmäßig zum
Ausgleich von Höhenunterschieden und von mechanischen
Spannungen. Sie werden zweckmäßig aus Molybdän hergestellt. Ausgleichstücke 7 sind jedoch nicht in jedem
Fall erforderlich.

Die metallisierte Oberseite der Grundplatte 2 und beide Seiten der Deckplatte 3 sind entsprechend der gewünschten Leiterbahnstruktur geätzt. Die Oberseite der Grundplatte 2 wird mit Leiterbahnebene I bezeichnet, die Unterseite der Deckplatte 3 mit Leiterbahnebene II und die Oberseite der Deckplatte 3 mit Leiterbahnebene III. Die Leiterbahnebenen I und II sind für Verbindungen vorgesehen, die den Laststrom führen, die Leiterbahnebene III für Hilfsverbindungen zur Steuerung der Halbleiterbauelemente 5. Die Leiterbahnebene III oder zusätzliche Leiterbahnebenen können auch mit elektronischen Bauelementen, z.B. integrierten Schaltkreisen, zur Ansteuerung der Halbleiterbauelemente 5 oder mit Regelfunktionen bestückt werden. Elektrische Verbindungen zwischen Leiterbahnen 9 der Ebene I und der Ebene II werden durch Kontaktstempel 10 hergestellt. Damit können auch komplexe Schaltungen durch Verteilung der Leitungsverbindungen über mehrere Ebenen realisiert werden.

Nach dem zuvor angegebenen Schema können auch mehr als zwei Substrate 2, 3 übereinander angeordnet werden, jeweils mit zwischengelegten Bauteilen 6, 10. Damit kann eine kompakte Bauweise erzielt werden, insbesondere wenn die abzuführende Verlustwärme nicht sehr hoch ist.

Die erfindungsgemäße Lösung ist nicht nur zur Realisierung von Stromrichterschaltungen mit mehereren gesteuerten Leistungshalbleiterbauelemente 5 geeignet, sondern auch für die Herstellung von Bauelementen mit nur einem Halbleiterbauelement 5.

In Fig. 1 ist weiterhin eine mögliche Ausführung der Fixierung eines Sandwich 6 und der Herstellung von Kontaktverbindungen zur Ebene III dargestellt.

Die Bauteile 6, 10 zwischen den Substraten 2, 3 müssen an der richtigen Stelle positioniert und während des Lötvorganges fixiert werden. Eine nicht in der Zeichnung dargestellte vorteilhafte Möglichkeit besteht darin, die Form der Leiterbahn 9 auf der Ebene I und/oder II so an die zu kontaktierenden Flächen der Bauteile 6, 10 anzupassen, daß die Bauteile 6, 10 während des Lötvorganges durch Kapillarkraft an der richtigen Stelle gehalten werden. Auf diese Weise kann z.B. der in Fig. 1 dargestellte Kontaktstempel 10 fixiert werden. Zur Positionierung des Halbleiter-Sandwich 6 ist im dargestellten Beispiel eine Bohrung 11 in der Deckplatte 3 vorgesehen, durch die eine keramische Zentrierhülse 12 gesteckt wird, die bis in die Öffnung 13 im oberen Ausgleichstück 7 ragt.

Die erforderliche elektrische Verbindung zwischen dem Gate-Anschluß 8 und einer Leiterbahn 9 zum Gatekontakt G auf der Leiterbahnebene III wird durch einen Kontaktdraht 14 hergestellt, der durch die Zentrierhülse 12 geführt wird. In der Nähe der Bohrung 11 ist in der Deckplatte 3 ein weiteres Loch 15 vorgesehen, durch das ein Kathodendraht 16 zur Herstellung des Hilfskathodenkontakts HK geführt wird.

In Fig. 2 ist in einer Detaildarstellung eine andere Möglichkeit zur Positionierung eines Sandwich 6 und zur Herstellung von Kontaktverbindungen zur Leiterbahnebene III gezeigt. Dabei ist eine keramische Hülse 17 mit einem Hülsenrand 18 vorgesehen, wobei die Hülse 17 stellenweise eine Metallisierung 19,20 trägt. Mit der in einem äußeren Bereich der Hülse 17 vorgesehenen Metallisierung 19 kann eine elektrische Verbindung zwischen Leiterbahnen 9 der Ebenen II und III hergestellt werden. Mit der Metallisierung 20, die im inneren Bereich der Hülse 17 beginnt und über den Rand 18 führt, kann die erforderliche Verbindung zwischen Gate-Anschluß am Halbleiterbauelement 5 und einer Leiterbahn 9 in der Ebene III hergestellt werden, die zu einem Gate-Kontakt G führt. Die Positionierung des Sandwich 6 erfolgt wie bei der Lösung gemäß Fig. 1 dadurch, daß die Hülse 17 durch die Bohrung 11 in der Deckplatte 3 in die Öffnung 13 des oberen Ausgleichstücks 7 ragt. Alle miteinander zu verbindenden Metallflächen sind vorbelotet, so daß die Verbindungen beim Lötvorgang selbsttätig hergestellt werden (Reflow-Verfahren).

Die in Fig. 2 dargestellte Lösung ist besonders gut geeignet für eine maschinelle Bestückung und damit eine automatisierte Fertigung.

Fig. 3 zeigt eine Möglichkeit zur Positionierung von Halbleiterbauelementen 5 oder anderen Bauteilen, wobei keramische Zentrierstifte 21 als Bestückungshilfen vorgesehen sind. Die Zentrierstifte 21 werden durch Bohrungen 11 in der Deckplatte 3 gesteckt und so um ein Bauelement 5 angeordnet, daß das Bauelement 5 vor und während der Lötung zwischen den Stiften 21 gehalten wird. Bei kreisrunden Bauelementen 5 sind drei Zentrierstifte 21 vorgesehen, die nach dem Lötvorgang wieder entfernt werden können.

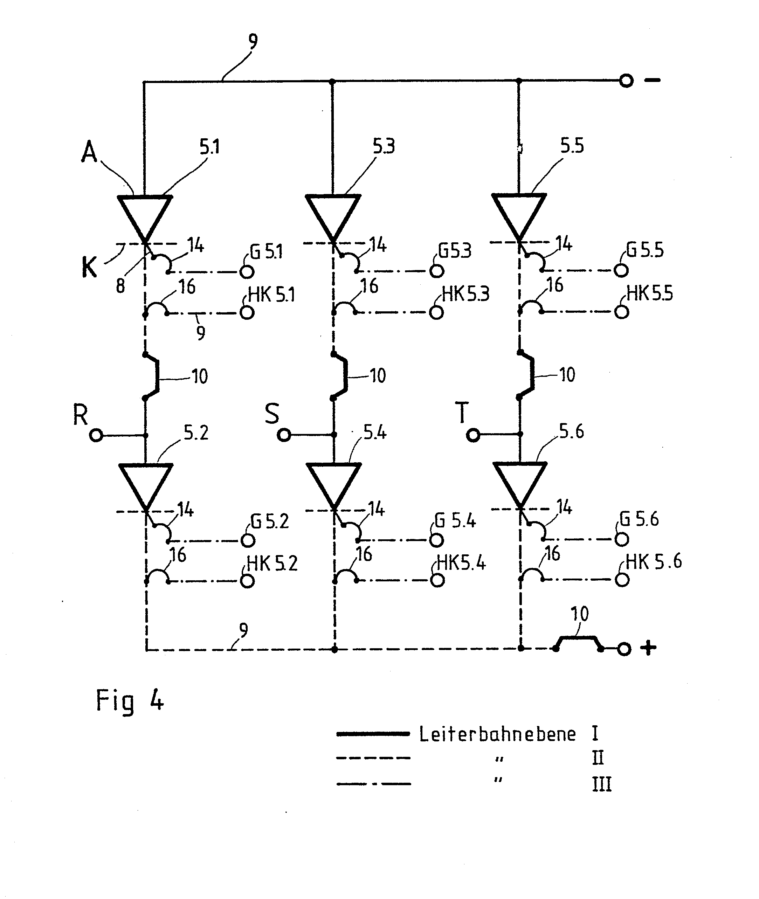

In den Fig. 4 bis 7 ist als Ausführungsbeispiel die Realisierung einer Drehstrombrückenschaltung dargestellt. Dabei ist die in Fig. 1 angegebene Lösung zur Positionierung von Halbleiterbauelementen 5 zwischen Ebenen I und II und zur Herstellung der elektrischen Verbindungen zur Ebene III zugrundegelegt.

Fig. 4 zeigt eine bekannte Drehstrombrückenschaltung mit sechs Thyristoren 5.1 bis 5.6 zur Umwandlung von Drehstrom in Gleichstrom. Die Anoden A des ersten Thyristors 5.1, des dritten und des fünften Thyristors 5.3 und 5.5 sind untereinander und mit dem Minuskontakt verbunden. Die Kathoden K der zweiten, vierten und sechsten Thyristoren 5.2, 5.4 und 5.6 sind untereinander und mit dem Pluskontakt verbunden. Die Kathode K des Thyristors 5.1 ist mit der Anode A des Thyristors 5.2 und mit dem Phasenkontakt R verbunden, die Kathode K des Thyristors 5.3 mit der Anode A des Thyristors 5.4 und mit dem Phasenkontakt S und die Kathode K des Thyristors 5.5 ist mit der Anode A des Thyristors 5.6 und dem Phasenkontakt T verbunden.

Zur Realisierung der Drehstrombrückenschaltung ist ein Leistungshalbleitermodul 1 mit zwei Substraten 2, 3 vorgesehen. In Fig. 4 ist nicht nur die elektrische Schaltung der Drehstrombrückenschaltung angegeben, sondern auch die Aufteilung der Leitungsführung auf die Leiterbahnebenen I bis III auf den Substraten 2, 3. Mit durchgezogenen Linien sind die Leiterbahnen 9 auf der Leiterbahnebene I angegeben. Leiterbahnen 9 in der Ebene II sind mit gestrichelten Linien gezeichnet und Leiterbahnen 9 in der Ebene III mit strichpunktierten Linien.

Außerdem ist in Fig. 4 eingetragen an welchen Stellen der Schaltung Kontaktstempel 10 zur Verbindung der Ebenen I und II vorgesehen sind. Weiterhin sind die in Fig. 1 dargestellten Kontaktdrähte 14 zur Verbindung der Gate-Anschlüsse 8 mit jeweils einem der Gate-Kontakte G5.1 bis G5.6 über Leiterbahnen 9 in der Ebene III eingezeichnet, sowie schließlich die Kathodendrähte 16 zu jeweils einem der Hilfskathodenkontakte HK5.1 bis HK5.6 über Leiterbahnen 9 der Ebene III.

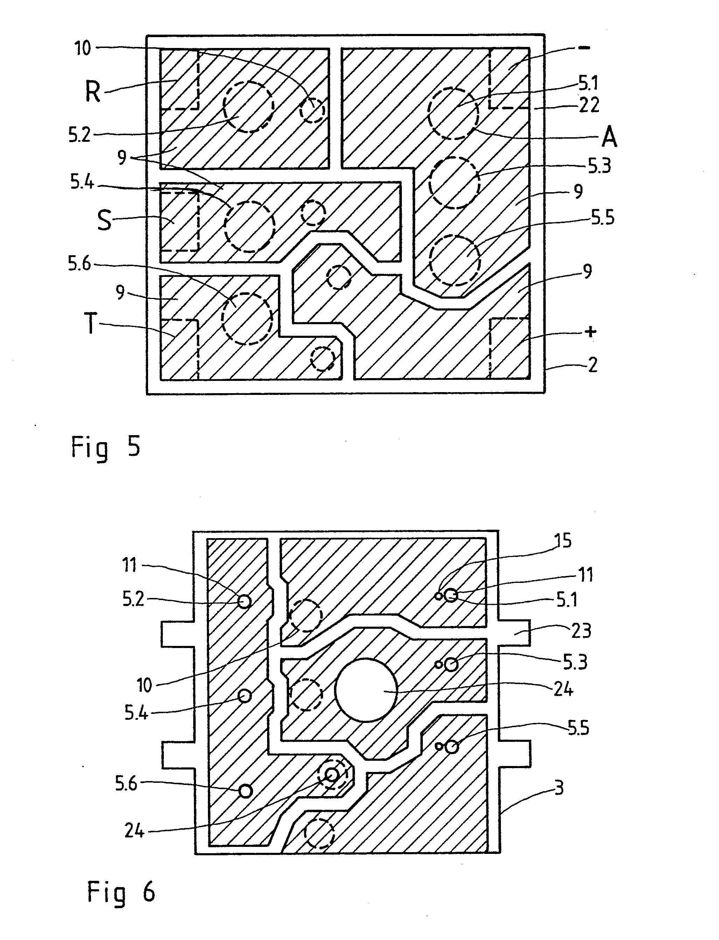

Die Figuren 5 bis 7 zeigen die Leiterbahnstrukturen der Drehstrombrückenschaltung aus Fig. 4 auf den Leiterbahnebenen I bis III.

Fig. 5 ist die Struktur der Leiterbahnen 9 in der Leiterbahnebene I auf der Oberseite der Grundplatte 2 zu entnehmen. Die metallisierten Flächen der Leiterbahnen 9 reichen nicht ganz bis zum Rand der Grundplatte 2, so daß ein nicht metallisierter Randstreifen 22 übrig bleibt, auf den ein nicht dargestelltes Kunststoffgehäuse aufgesetzt und z.B. verklebt werden kann. Gestrichelte große Kreise geben die Orte an, an denen die Thyristoren 5.1 bis 5.6 jeweils mit ihren Anoden 8 aufgelötet werden. Gestrichelte kleine Kreise geben die Stellen an, an denen Kontaktstempel 10 aufgelötet werden. Gestrichelte Rechtecke deuten die Flächen an, auf die R-, S-, T-Kontakte sowie Plus- und Minuskontakte aufgelötet werden, die z.B. nach oben zu äußeren Anschlüssen am Gehäuse führen.

Fig. 6 zeigt die Struktur der Leiterbahnen 9 in der Leiterbahnebene II auf der Unterseite der Deckplatte 3. Dargestellt ist eine Ansicht, die man von oben hätte, wenn die Deckplatte 3 durchsichtig wäre. Die äußeren Abmessungen der Deckplatte 3 sind im Vergleich zur Grundplatte 2 etwas geringer und zwar um die Breite des Randes 22 auf der Grundplatte 2, damit ein Gehäuse über die Deckplatte 3 gestülpt werden kann. Links und rechts an der Deckplatte 3 sind Ausschnitte vorgesehen, so daß nur Nasen 23 zur Führung des Gehäuses stehen bleiben. In den Ausschnitten werden z.B. Flachstecker für die Kontakte R, S, T sowie Plus und Minus nach oben geführt. In der Mitte der Deckplatte 3 ist eine große Bohrung 24 vorgesehen, zum späteren Einfüllen von Vergußmasse. Gestrichelte Kreise zeigen, wo Kontaktstempel 10 eingelötet werden, die Ebene I mit Ebene II verbinden. Die Bohrungen 11 zeigen jeweils den Mittelpunkt des Einbauorts der Thyristoren 5.1 bis 5.6 an. Die kleinen Löcher 15 zur Durchführung der Kathodendrähte 16 sind bei den Thyristoren 5.1, 5.3 und 5.5 jeweils eng neben den Bohrun gen 11 angeordnet. Das gemeinsame Kathodenpotential der Thyristoren 5.2, 5.4 und 5.6 wird mit einem Draht 16 durch eine Bohrung 25 in die Ebene III geführt. Unterhalb der Bohrung 25 ist ein Kontaktstempel 10 angeordnet.

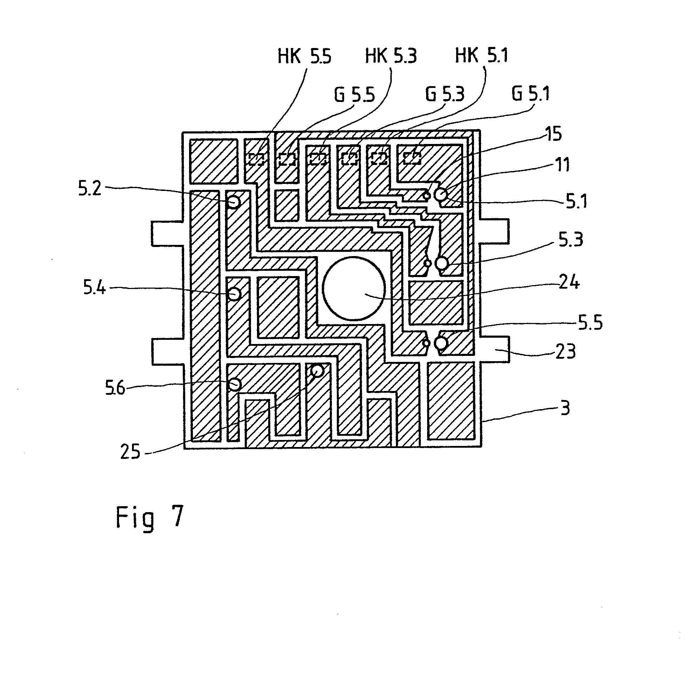

Fig. 7 zeigt schließlich die Struktur der Leiterbahnen 9 in der Ebene 3 auf der Oberseite der Deckplatte 3. Die durchgehenden Bohrungen 11, 15, 24, 25 wurden bereits im Rahmen der vorstehenden Beschreibung der Fig. 6 erläutert. Mit gestrichelten Rechtecken sind die vorgesehenen Flächen angedeutet zum Anlöten von Drähten für die Hilfskathodenanschlüsse HK5.1 bis HK5.6 und Gate-Anschlüsse G5.1 bis G5.6 zur Steuerung der Thyristoren 5.1 bis 5.6.

Zur Herstellung des erfindungsgemäßen Leistungshalbleitermoduls wird keine komplizierte Lötform benötigt, sondern lediglich ein einfacher Lötrahmen, in den nacheinander die Grundplatte 2, die aufzulötenden Halbleiter-Sandwich 6 und Kontaktstempel 10 sowie die Deckplatte 3 eingesetzt werden. In die Bohrungen 11 werden Hülsen 12 gesteckt und in die Hülsen 12 sowie die Löcher 15, 25 werden Drähte 14, 16 gesteckt. Außerdem werden Flachstecker für die Kontakte eingelegt. Die Teile sind vorgelötet und erforderlichenfalls werden Lotplättchen zwischengelegt. In einem Lötvorgang werden alle Teile miteinander verbunden.

Wie bereits erwähnt, kann ein erfindungsgemäßes Leistungshalbleitermodul 1, das sandwichartig aufgebaut ist, in ein Kunststoffgehäuse eingesetzt und vergossen werden. Das erfindungsgemäße Modul 1 kann aber auch ohne eigenes Gehäuse wie ein sonstiges Bauelement im Rahmen einer umfangreicheren Anordnung eingesetzt werden, die als ganzes gekapselt wird.

Bei einem erfindungsgemäßen Modul 1 kann auch eine Grundplatte 2 als Gehäuseboden und ein oberes Substrat 3 als Gehäusedeckel dienen. Ein solches Modul 1 kann oben und unten mit einem Kühlkörper kontaktiert werden. Anschlüsse können bei einer solchen Anordnung seitlich herausgeführt werden.

A n s p r ü c h e

1. Leistungshalbleitermodul mit mindestens zwei parallel zueinander angeordneten mindestens auf einer Seite metallisierten Keramikplatten (Substrate), dadurch gekennzeichnet, daß zwischen jeweils zwei Substraten (2,3) mindestens ein gesteuertes Leistungshalbleiterbauelement (5) angeordnet ist, wobei das gesteuerte Leistungshalbleiterbauelement (5) direkt oder über Ausgleichstücke (7) mit einer Metallisierung (4) auf den Substraten (2,3) über und unter dem gesteuerten Leistungshalbleiterbauelement (5) kontaktiert ist und wobei das Substrat (3) über dem gesteuerten Leistungshalbleiterbauelement (5) Bohrungen (11) zur Durchführung von Steueranschlüssen (z.B. 14,16) aufweist.

2. Leistungshalbleitermodul nach Anspruch 1, dadurch gekennzeichnet, daß das Leistungshalbleitermodul (1) in ein Gehäuse eingesetzt ist, das zumindest teilweise mit einer Vergußmasse ausgefüllt ist.

3. Leistungshalbleitermodul nach Anspruch 1, dadurch gekennzeichnet, daß die Metallisierung (4) auf mindestens einer Seite der Substrate (2,3) zu Leiterbahnen (9) strukturiert ist.

4. Leistungshalbleitermodul nach wenigstens einem der Ansprüche 1 bis 3, dadurch gekennzeichnet, daß zur Verbindung von Leiterbahnen (9) auf zwei einander zugewandten Leiterbahnebenen (I,II) der Substrate (2,3) Kontaktstempel (10) vorgesehen sind.

5. Leistungshalbleitermodul nach wenigstens einem der Ansprüche 1 bis 4, dadurch gekennzeichnet, daß Hilfsstromkreise zur Steuerung getrennt vom Laststromkreis auf einer gesonderten Leiterbahnebene (III) eines Substrats (3) angeordnet sind.

6. Leistungshalbleitermodul nach wenigstens einem der Ansprüche 1 bis 5, dadurch gekennzeichnet, daß zwischen gesteuerten Leistungshalbleiterbauelementen (5) und Substraten (2,3) zum Ausgleich von Höhenunterschieden und/oder mechanischen Spannungen Ausgleichstücke (7) vorgesehen sind.

7. Leistungshalbleitermodul nach wenigstens einem der Ansprüche 1 bis 6, dadurch gekennzeichnet, daß zur Positionierung der Bauelemente (5,6) oder anderer Bauteile im Leistungshalbleitermodul (1) vor und während einer Lötung elektrisch isolierende und wärmebeständige Zentrierstifte (21) vorgesehen sind.

8. Leistungshalbleitermodul nach wenigstens einem der Ansprüche 1 bis 7, dadurch gekennzeichnet, daß zur Positionierung der Bauelemente (5,6) Zentrierhülsen (12) vorgesehen sind, die durch eine Bohrung (11) in einer Deckplatte (3) und einer Öffnung (13) im Ausgleichstück (7) über einem Halbleiterbauelement (5) gesteckt werden.

9. Leistungshalbleitermodul nach wenigstens einem der Ansprüche 1 bis 8, dadurch gekennzeichnet, daß zur Positionierung der Bauelemente (5,6) eine Hülse (17) mit einem Hülsenrand (18) vorgesehen ist, die stellenweise Metallisierungen (19,20) aufweist zur Verbindung von Leiterbahnen (9) auf Leiterbahnebenen (II,III) auf der Unter- und Oberseite der Deckplatte (3) sowie zur Verbindung eines Gate-Anschlusses (8) am gesteuerten Leistungshalbleiterbauelement (5) bzw. Halbleiter-Sandwich (6) mit einer Leiterbahn (9) auf der für Hilfsstromkreise vorgesehenen Leiterbahnebene (III).

10. Leistungshalbleitermodul nach wenigstens einem der Ansprüche 1 bis 9, dadurch gekennzeichnet, daß an den Stellen im Leistungshalbleitermodul (1), an denen Kontaktstempel (10) vorgesehen sind, die Form der Leiterbahnen (9) über und/oder unter den Kontaktstempeln (10) der Kontaktfläche der Kontaktstempel (10) angepaßt ist, so daß die Kontaktstempel (10) während einer Lötung mit Hilfe der Kapillarkraft gehalten werden.

11. Leistungshalbleitermodul nach wenigstens einem der Ansprüche 1 bis 8, dadurch gekennzeichnet, daß zur elektrischen Verbindung von Gate-Anschlüssen (8) an Bauelementen (5,6) mit Leiterbahnen (9) auf der für Hilfsstromkreise vorgesehenen Leiterbahnebene (III) vorgelötete Kontaktdrähte (14) vorgesehen sind.

12. Leistungshalbleitermodul nach wenigstens einem der Ansprüche 1 bis 11, dadurch gekennzeichnet, daß eine Grundplatte (2) etwas größere Abmessungen hat als weitere darüber angeordnete Substrate (3).

13. Leistungshalbleitermodul nach wenigstens einem der Ansprüche 1 bis 12, dadurch gekennzeichnet, daß die Metallisierung (4) auf den Substraten (2,3) durch Direct-Bonding hergestellt ist.

14. Leistungshalbleitermodul nach wenigstens einem der Ansprüche 1 bis 13, dadurch gekennzeichnet, daß die Grundplatte (2) mit einem Kühlkörper kontaktiert ist.

15. Leistungshalbleitermodul nach wenigstens einem der Ansprüche 1 bis 14, dadurch gekennzeichnet, daß auch die Oberseite des Leistungshalbleitermoduls (1) mit einem Kühlkörper kontaktiert ist.

16. Leistungshalbleitermodul nach wenigstens einem der Ansprüche 1 bis 15, dadurch gekennzeichnet, daß Kontaktanschlüsse (R,S,T, +, - H,K,G) am Leistungshalbleitermodul (1) seitlich herausgeführt sind.

17. Leistungshalbleitermodul nach wenigstens einem der Ansprüche 1 bis 16, dadurch gekennzeichnet, daß ein integrierter Schaltkreis mit Ansteuer- und Regelfunktionen in das Modul eingebaut ist.

18. Leistungshalbleitermodul nach wenigstens einem der Ansprüche 1 bis 17, dadurch gekennzeichnet, daß ein oberes Substrat (3) und eine Grundplatte (2) einen Gehäusedeckel bzw. -boden bilden.

0152818

1/4

Fig. 1

Fig 2

Fig 3

Fig 4

| | |
|---|---|
| ——— | Leiterbahnebene I |
| - - - | " II |
| —·—·— | " III |

Fig 5

Fig 6

0152818

4/4

Fig 7